# EUROPEAN PATENT SPECIFICATION

(11) **EP 0 501 657 B1**
(45) Date of publication and mention of the grant of the patent: **24.06.1998**
(21) Application number: 92301330.4
(22) Date of filing: 19.02.1992
(51) Int. Cl.: G03C 7/12, G03F 7/16, G02F 1/1335

(54) **Method of manufacturing a colour filter**
Verfahren zur Herstellung eines Farbfilters
Procédé pour produire un filtre coloré

(30) Priority: 25.02.1991 JP 30464/91
(43) Date of publication of application: 02.09.1992
(73) Proprietor: SEIKO INSTRUMENTS INC., Tokyo 136 (JP); SHINTO CHEMITRON Co. Ltd., Tokyo (JP)
(72) Inventor: Kamamori, Hitoshi, c/o Seiko Instruments Inc., Tokyo (JP); Suginoya, Mitsuru, c/o Seiko Instruments Inc., Tokyo (JP); Watanabe, Tsutomu, c/o Shinto Chemitron Co. Ltd., Chuo-ku, Tokyo (JP); Ota, Toshiaki, c/o Shinto Chemitron Co. Ltd., Chuo-ku, Tokyo (JP); Iwasa, Koji c/o Seiko Instruments Inc., Tokyo (JP); Fukuchi, Takakazu c/o Seiko Instruments Inc., Tokyo (JP); Yasumawa, Junichi c/o Shinto Chemitron Co. Ltd., Chuo-ku, Tokyo, (JP)
(74) Representative: Sturt, Clifford Mark

(56) References cited:
- EP-A- 0 338 412
- PATENT ABSTRACTS OF JAPAN vol. 015, no. 116 (P-1182)20 March 1991
- PATENT ABSTRACTS OF JAPAN vol. 013, no. 443 (P-941)5 October 1989
- PATENT ABSTRACTS OF JAPAN vol. 014, no. 008 (P-987)10 January 1990
- PATENT ABSTRACTS OF JAPAN vol. 014, no. 240 (P-1051)22 May 1990

## Description

The present invention relates to a method of manufacturing a colour filter, and although the invention is not so restricted, it relates more particularly to the manufacture of a colour filter used for a liquid crystal colour display and a coloured scale of a video image camera.

The most convenient method of producing a colour filter comprising an organic polymer and a colouring material, is by printing. However, printing has the problem that accurate positioning during multicolour printing is difficult, and high accuracy and a fine pattern cannot be achieved. A colour filter having high accuracy and a very fine pattern, for use in a camera or the like, is therefore usually produced by photo-lithography. Although, however, photo-lithography provides a sufficiently high accuracy and fineness, a separate photo-lithographic process has to be carried out for each colour, and this makes the manufacture extremely complicated. In addition, there is a limit to the size of the substrate that can be used, due to limits imposed on devices used during manufacture, such as an aligner.

Recently, a method of manufacturing a colour filter has been developed by forming colour layers by electrodeposition. The method has a relatively simple process and produces a relatively high accurate pattern.

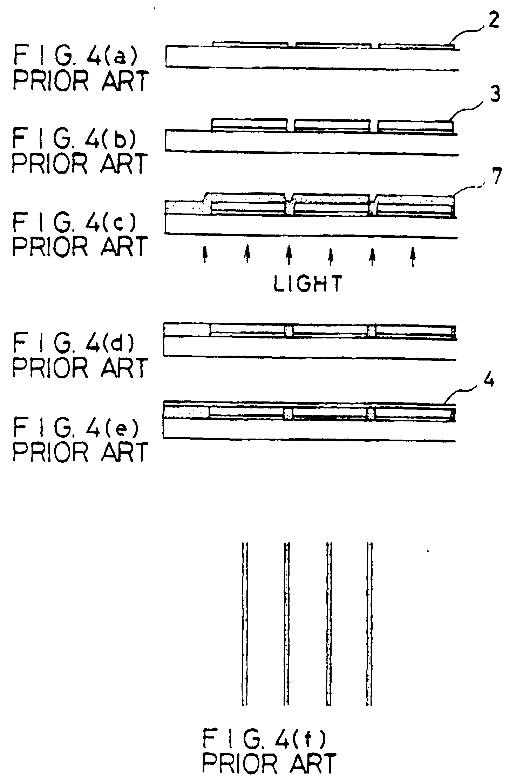

As shown in Fig. 4 in this conventional colour pattern manufacturing process using electrodeposition, a coloured layer 3 (as shown in Fig. 4(b) is formed by electrodeposition over a conductive film 2 (as shown in Fig. 4(a)) having an arbitrary pattern. Next, a negative type photosensitive resin 7 having black pigments dispersed therein is applied (as shown in Fig. 4(c)). The substrate, usually glass, has its back exposed (as shown in Fig. 4 (c)) by using the coloured layer as a photo mask. After development (as shown in Fig. 4(d)), a transparent conductive film 4 is formed (as shown in Fig. 4 (e)).

Liquid crystal displays of the thin film technology type have been expected in recent years to have a promising future. However, a shielding film is required to improve its shielding efficiency so as to prevent optical leakage when used as a switching element. In order to improve image quality, the shielding film is required to have a lattice-shaped pattern. In the existing manufacture process, however, black pigment is dispersed in the resist so that the shielding film can only be added in limited amounts and thereby fails to have the required shielding efficiency. Since, moreover, the shielding film is formed by the exposure of the substrate back using the coloured layer as the mask, there arises a problem in that it is difficult to form the shielding film into the lattice shape.

One known colour filter for use in a liquid crystal display is described in European Patent Publication No. 0338412. This describes a method of forming a colour filter on a substrate in which an Indium tin oxide film is formed into an electrode pattern on a substrate and colour filters are formed on the electrodes by electrodeposition. A light shielding layer is then formed by printing in the spaces between the colour filters. It is suggested that the light shielding layer could be formed by a metallic film.

It is, therefore, an object of the present invention to solve the above-specified problem of the prior art and to provide a process for manufacturing a multi-colour pattern having a shielding film which has a high shielding efficiency and can be formed into an arbitrary pattern shape.

According to a first aspect of the present invention, there is provided a method of manufacturing a colour filter comprising:
forming a conductive film having a first arbitrary pattern on an insulative surface of a substrate;
forming a coloured layer over the conductive film by electrodeposition;
characterised by
forming a transparent conductive film over the coloured layer; and
forming a metal film having a second arbitrary pattern on the coloured layer and/or the transparent conductive film, so as to shield undesirable light being transmitted through the gaps between the first arbitrary pattern of the coloured layer.

In the colour pattern manufacturing process thus constructed, the shielding film used is exemplified by the metal film so that a high shielding efficiency can be achieved. Since, moreover, the metal film can be easily patterned into an arbitrary shape by a lift-off method or an etching method, it is possible to form a shielding film having a pattern shape suited for a variety of display device systems.

The present invention now will be described in the following in connection with the preferred embodiments thereof with reference to the accompanying drawings, of which

Fig. 1 is a first example of the present invention for producing a colour filter.

Fig. 2 is a second example of the present invention for producing a colour filter.

Fig. 3 is a third example of the present invention for producing a colour filter

Fig. 4 illustrates the prior art.

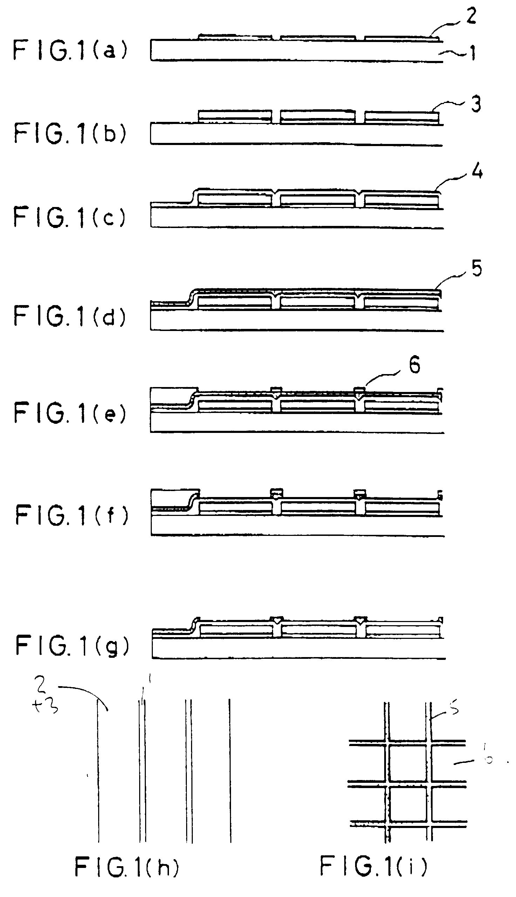

Fig. 1 shows a first example of manufacturing a colour filter and is as follows:
(1) An indium tin oxide (ITO) film 2 is formed over an insulating film or substrate 1 by a sputtering method and etched (as shown in Fig. 1(a)) into an electrically depositable arbitrary pattern. This electrically depositable pattern is a stripe pattern, as shown in Fig. 1 (h).
(2) A coloured layer 3 is formed (as shown in Fig. 1 (b)) over the ITO film by an electrodeposition method. When two or more colours are required, the corresponding number of coloured layers is formed at this time. The electrodepositions may be repeated for the individual colours.
(3) Another ITO film 4 is formed (as shown in Fig. 1(c)) by a sputtering method. Since the coloured layer was already formed over the substrate, the filming temperature may desirably be at 250°C or less. Incidently, the ITO film may be used as a driving electrode when the colour filter is used as part of a display device.
(4) Moreover, a metal film 5, for example chromium (Cr) or the like, is formed (as shown in Fig. 1(d)) by a sputtering method or other suitable method. This metal film is used as a shielding film.
(5) A photoresist 6 is exposed and developed (as shown in Fig. 1(e)) into a desired shielding pattern. The pattern shape can be an arbitrary one such as a lattice-shaped pattern, as shown in Fig. 1(i).
(6) The metal film is etched (as shown in Fig. 1(f)).
(7) The photoresist is peeled off (as shown in Fig. 1(g)).

By the steps described above, a shielding film having a shielding efficiency of 100% and a lattice-shaped pattern can be formed remarkably simply so as to realise a remarkably convenient multi-colour pattern manufacturing process together with electrodeposition.

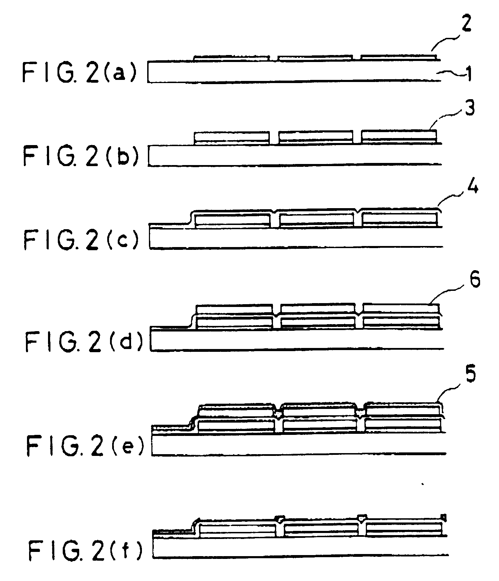

Fig. 2 shows a second example of manufacturing a colour filter and the steps are as follows:
(1) The colour layer 3 and the ITO film 4 are formed (as shown in Figs. 2(a), 2(b), and 2(c)) like the first example.
(2) The photoresist 6 is exposed and developed (as shown in Fig. 2(d) into a desired shielding film pattern.
(3) The metal film 5 of Cr or the like is formed (as shown in Fig. 2(e)) by the sputtering method but in this case after forming the photoresist shielding pattern.
(4) The photoresist is peeled off (as shown in Fig. 2(f)).

This example is a process for patterning the metal film using a lift-off method and so can dispense with etching the metal film. In contrast to the first example this simplifies the manufacturing more.

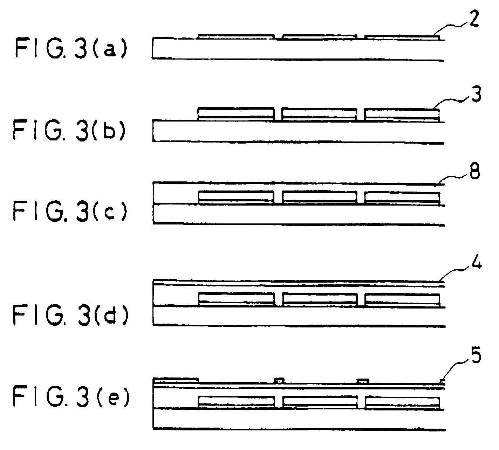

Fig. 3 shows a third example of manufacturing a colour filter, the steps of which are as follows:
(1) The coloured layer 3 is formed (as shown in Figs. 3(a) and 3(b)) like the first example.
(2) An organic film 8 is applied by a spinner and set (as shown in Fig. 3(c)). The organic film may preferably be made of a high levelling material such as an epoxy resin or an acrylic resin.
(3) The ITO film 4 is formed (as shown in Fig. 3(d)) by the sputtering method or the like.
(4) Like the first and second example, the metal film 5 of Cr or the like is formed into a lattice shape (as shown in Fig. 3(e)).

Since the recesses of the gaps of the coloured layer can be buried in the organic film but have a flattened surface in accordance with the present example, the multi-colour pattern is more effective when the colour filter is used as a display device than those of the foregoing examples.

In a fourth example, a SiO₂ film was formed before formation of the further ITO film 4 of any of the foregoing examples by a sputtering method. As a result, contact of the ITO film 4 was improved. Similar results were obtained by an inorganic film other than the SiO₂ film.

As has been described hereinbefore, according to the present invention, after the ITO film has been formed over the coloured layer, the metal film is formed as the shielding film. As a result, there can be attained, by this remarkably simple process, improvements in the shielding efficiency of the shielding film, which has been impossible in the prior art, and has the capability of forming the shielding film in an arbitrary pattern. Since, moreover the first ITO film and the metal film are laminated, another effect is that the later ITO film is laminated, another effect is that the ITO film can have its final resistance reduced by the metal film even if ordinarily it has a high resistance. Furthermore, since the ITO film can be thinned, it is possible to improve the transparency of the ITO film and to shorten the time period for forming the ITO film. The former can lead to an improvement in the quality of the multi-colour pattern itself, and the latter can contribute to a reduction in the cost of manufacturing.

## Claims

1. A method of manufacturing a colour filter comprising:
forming a conductive film (2) having a first arbitrary pattern on an insulative surface of a substrate (1);
forming a coloured layer (3) on the conductive film (2) by electrodeposition;
characterised by
forming a transparent conductive film (4) over the coloured layer (3); and
forming a metal film (5) having a second arbitrary pattern over the coloured layer (3) and/or the transparent conductive film (4), so as to shield undesirable light being transmitted through the gaps between the first arbitrary pattern of the coloured layer.

2. A method of manufacturing a colour filter according to claim 1, further including forming an inorganic film on the coloured layer (3) before forming the transparent conductive film (4).

3. A method of manufacturing a colour filter according to claim 1, further including forming an organic film (8) over the coloured layer (3) .

4. A method of manufacturing a colour filter as claimed in any one of the preceding claims, in which forming said metal film comprises depositing, developing and exposing a photoresist (6) to form said second arbitrary pattern either before depositing said metal film (5) and then etching said metal film or after sputtering said metal film and then peeling off said photoresist.

5. A method of manufacturing a colour filter according to any one of the preceding claims, wherein the first arbitrary pattern of the conductive film is a stripe pattern.

6. A method of manufacturing a colour filter according to any one of the preceding claims, wherein the second arbitrary pattern of the metal film is a lattice-shaped pattern.

7. A method of manufacturing a colour filter according to claim 6, wherein the metal film also shields light passing through some part of the coloured layer where the lattice pattern is formed.

## Patentansprüche

1. Verfahren zum Herstellen eines Farbfilters, umfassend:
Bilden eines leitfähigen Films (2), der ein erstes beliebiges Muster aufweist, auf einer isolierenden Oberfläche eines Substrats (1);
Bilden einer farbigen Schicht (3) auf dem leitfähigen Film (2) durch Elektrodeposition;
gekennzeichnet durch
Bilden eines transparenten leitfähigen Films (4) über der farbigen Schicht (3); und
Bilden eines Metallfilms (5), der ein zweites beliebiges Muster aufweist, über der farbigen Schicht (3) und/oder dem transparenten leitfähigen Film (4), um unerwünschtes Licht abzuschirmen, das durch die Lücken zwischen dem ersten beliebigen Muster der farbigen Schicht hindurch transmittiert wird.

2. Verfahren zum Herstellen eines Farbfilters nach Anspruch 1, ferner umfassend ein Bilden eines anorganischen Films auf der farbigen Schicht (3) vor der Bildung des transparenten leitfähigen Films (4).

3. Verfahren zum Herstellen eines Farbfilters nach Anspruch 1, ferner umfassend ein Bilden eines organischen Films (8) über der farbigen Schicht (3).

4. Verfahren zum Herstellen eines Farbfilters nach einem der vorangegangenen Ansprüche, bei welchem das Bilden des Metallfilms eine Deposition, ein Entwickeln und ein Belichten eines Photoresists (6) umfaßt, um das zweite beliebige Muster entweder vor der Deposition des Metallfilms (5) und dann der Ätzung des Metallfilms oder nach einem Sputtern des Metallfilms und dann Ablösen des Photoresists zu bilden.

5. Verfahren zum Herstellen eines Farbfilters nach einem der vorangegangenen Ansprüche, wobei das erste beliebige Muster des leitfähigen Films ein Streifenmuster ist.

6. Verfahren zum Herstellen eines Farbfilters nach einem der vorangegangenen Ansprüche, wobei das zweite beliebige Muster des Metallfilms ein gitterförmiges Muster ist.

7. Verfahren zum Herstellen eines Farbfilters nach Anspruch 6, wobei der Metallfilm auch Licht abschirmt, welches durch einen Teil der farbigen Schicht hindurchtritt, an dem das Gittermuster ausgebildet ist.

## Revendications

1. Procédé de fabrication d'un filtre coloré, qui comprend :
la formation d'un film conducteur (2), ayant un premier dessin arbitraire, sur une surface isolante d'un substrat (1) ;
la formation d'une couche colorée (3) sur le film conducteur (2) par électrodéposition ;
caractérisé par
la formation d'un film conducteur transparent (4) sur la couche colorée (3) ; et
la formation d'un film métallique (5) ayant un deuxième dessin arbitraire sur la couche colorée (3) et/ou le film conducteur transparent (4), de façon à occulter la lumière indésirable transmise par les interstices entre le premier dessin arbitraire de la couche colorée.

2. Procédé de fabrication d'un filtre coloré selon la revendication 1, qui comprend en outre la formation d'un film inorganique sur la couche colorée (3) avant la formation du film conducteur transparent (4).

3. Procédé de fabrication d'un filtre coloré selon la revendication 1, qui comprend en outre la formation d'un film organique (8) sur la couche colorée (3).

4. Procédé de fabrication d'un filtre coloré selon l'une quelconque des revendications précédentes, dans lequel la formation dudit film métallique comprend le dépôt, le développement et l'exposition d'une photoréserve (6) pour former ledit deuxième dessin arbitraire, soit avant dépôt dudit film métallique (5), puis gravure dudit film métallique, soit après application dudit film métallique par pulvérisation cathodique, puis enlèvement de ladite photoréserve par pelage.

5. Procédé de fabrication d'un filtre coloré selon l'une quelconque des revendications précédentes, dans lequel le premier dessin arbitraire du film conducteur est un dessin en bandes.

6. Procédé de fabrication d'un filtre coloré selon l'une quelconque des revendications précédentes, dans lequel ledit deuxième dessin arbitraire du film métallique est un dessin en treillis.

7. Procédé de fabrication d'un filtre coloré selon la revendication 6, dans lequel le film métallique occulte aussi la lumière traversant une certaine partie de la couche colorée où est formé le dessin en treillis.
